# EUROPÄISCHE PATENTSCHRIFT

(11) **EP 2 996 157 B1**
(45) Veröffentlichungstag und Bekanntmachung des Hinweises auf die Patenterteilung: **25.05.2016**
(21) Anmeldenummer: 14184145.2
(22) Anmeldetag: 09.09.2014
(51) Int. Cl.: H01L 31/02, H02H 1/00, H02H 7/00

(54) **Verfahren zum Detektieren von und Detektionsvorrichtung für Lichtbögen in einer Photovoltaikanlage**
Method for detecting of and detection device for electric arcing in a photovoltaic system
Procédé de détection et dispositif de détection d'arcs électriques dans une installation photovoltaïque

(43) Veröffentlichungstag der Anmeldung: 16.03.2016
(73) Patentinhaber: SMA Solar Technology AG, 34266 Niestetal (DE)
(72) Erfinder: Merz, Christopher, 34117 Kassel (DE)
(74) Vertreter: Lahnor, Peter

(56) Entgegenhaltungen:
- US-A1- 2008 147 335
- US-A1- 2011 141 644
- US-A1- 2011 267 721
- US-A1- 2012 318 320
- US-A1- 2013 026 840

## Beschreibung

### TECHNISCHES GEBIET DER ERFINDUNG

Die Erfindung bezieht sich auf ein Verfahren zum Detektieren von Lichtbögen in einer Photovoltaikanlage mit einem Wechselrichter und mit mehreren, über Sammelleitungen an den Wechselrichter parallel angeschlossenen Stromsammeleinheiten, wobei an jede Stromsammeleinheit mehrere Strings von Photovoltaikmodulen über Stringleitungen parallel angeschlossen sind, wobei das Verfahren die Merkmale des Oberbegriffs des unabhängigen Patentanspruchs 1 aufweist. Weiterhin bezieht sich die Erfindung auf eine Detektionsvorrichtung für Lichtbögen in einer solchen Photovoltaikanlage mit den Merkmalen der Oberbegriffe der unabhängigen Patentansprüche 7 und 8.

Die hier als Wechselrichter bezeichnete Einheit der Photovoltaikanlage umfasst zumindest einen DC/AC-Wandler, der die von den Photovoltaikmodulen generierten Gleichströme in einen Wechselstrom umrichtet. Typischerweise umfasst der Wechselrichter neben dem DC/AC-Wandler Stromschienen, an die die einzelnen Sammelleitungen direkt oder über DC/DC-Wandler angeschlossen sind. An diese Stromschienen können auch mehrere DC/AC-Wandler angeschlossen sein, beispielsweise einer für jede Phase des Wechselstroms. Häufig sind auch Schalter zum Zuschalten der einzelnen Stromsammeleinheiten und/oder zum Zuschalten des oder der DC/AC-Wandler an ein ausgangsseitiges Wechselstromnetz und dergleichen vorhanden.

Die Stromsammeleinheiten der Photovoltaikanlage werden auch als Combiner oder Combinerboxen bezeichnet. Die von ihnen zu dem Wechselrichter verlaufenden Sammelleitungen heißen häufig Homeruns. In einer Stromsammeleinheit können einige oder auch viele Strings von Photovoltaikmodulen parallel geschaltet sein. Häufig sind in den Stromsammeleinheiten auch Sicherungen und/oder Dioden zum Schutz gegen Rückströme, manchmal auch Schalter zum Zuschalten der einzelnen Strings vorgesehen.

Gelegentlich, nicht aber in der vorliegenden Beschreibung und den angehängten Patentansprüchen, werden die über eine Stromsammeleinheit parallel geschalteten Strings einzeln auch als Substrings bezeichnet, und erst die Gesamtheit der über eine Stromsammeleinheit parallel geschalteten Substrings wird dann String genannt.

Für den Fall, dass zwischen die Strings und den DC/AC-Wandler des Wechselrichters kein DC/DC-Wandler geschaltet ist, ist die zwischen den Stringleitungen anliegende Spannung bei der Photovoltaikanlage genauso groß wie die zwischen den Sammelleitungen anliegende Spannung und auch wie die zwischen den Stromschienen des Wechselrichters anliegende Spannung. Durch die Parallelschaltungen in den Stromsammeleinheiten und dem Wechselrichter steigt aber die Stromstärke an. Typischerweise liegt die gleichbleibende Spannung im Bereich einiger hundert bis weniger tausend Volt, wobei höhere Spannungen mit dem Vorteil verbunden sind, dass kleinere Stromstärken und damit auch kleinere Leitungsquerschnitte zum Leiten gleicher elektrischer Leistungen ausreichend sind.

Infolge von Isolierungsfehlern der Isolierung zwischen den Stringleitungen jedes Strings, zwischen den Sammelleitungen jedes Paars von Sammelleitungen und zwischen den Stromschienen des Wechselrichters sowie zwischen jeder dieser Leitungen und Stromschienen gegenüber Erde bzw. auf Erdpotential liegenden Komponenten der Photovoltaikanlage können Lichtbögen auftreten. Die Lichtbögen, die zwischen den Stringleitungen, den Sammelleitungen oder den Stromschienen des Wechselrichters oder zwischen einer dieser Leitungen und Erde auftreten, werden üblicherweise als Parallel-Lichtbögen bezeichnet. Neben den Parallel-Lichtbögen kann auch innerhalb einer der genannten Leitungen oder an deren elektrischen Verbindung zu einer anderen Leitung desselben elektrischen Potentials ein Lichtbogen auftreten, der dann als Serien-Lichtbogen bezeichnet wird. Ursache eines Serien-Lichtbogen kann beispielsweise eine lokal begrenzte Beschädigung der Leitung oder ein erhöhter Übergangswiderstand an einer elektrischen Verbindung zu der Leitung sein. Auch ein defekter, z. B. nicht korrekt öffnender Schalter kann einen Lichtbogen über seinen Kontakten hervorrufen. Beide Arten von Lichtbögen - d. h. sowohl Parallel- als auch Serien-Lichtbögen - stellen ein zusätzliches Gefahrenpotential zu den Isolierungsfehlern selbst dar. So können brennende Lichtbögen beispielsweise bestehende Isolierungsfehler vergrößern, wie auch andere weitergehende Schäden hervorrufen. Hierzu zählt auch die Verursachung eines Brands der Photovoltaikanlage. Es ist daher wichtig, in einer Photovoltaikanlage auftretende Lichtbögen frühzeitig zu detektieren, um sie löschen und ihre Ursachen beseitigen zu können.

### STAND DER TECHNIK

Ein Verfahren mit den Merkmalen des Oberbegriffs des unabhängigen Patentanspruchs 1 und eine Detektionsvorrichtung mit den Merkmalen der Oberbegriffe der unabhängigen Patentansprüche 7 und 8, bei denen Messwerte elektrischer Größen an mindestens einer der Stringleitungen je String in den Stromsammeleinheiten erfasst werden, die Messwerte der elektrischen Größen auf das Vorliegen von Hinweisen auf einen Lichtbogen in der Photovoltaikanlage analysiert werden und Lichtbogensignale, die das Vorhandensein eines Lichtbogens in der Photovoltaikanlage anzeigen, generiert werden, wenn die vorliegenden Hinweise auf den Lichtbogen vorgegebene Kriterien erfüllen, sind bekannt. Mit dem Lichtbogensignal wird ein Arc Fault Circuit Interruptor (AFCl) aktiviert. Die elektrischen Größen, deren Messwerte zur Lichtbogendetektion erfasst werden, sind beispielsweise die DC-Spannung zwischen den Stringleitungen, die DC-Spannung der einzelnen Stringleitungen gegenüber Erdpotential, der DC-Strom durch die Stringleitungen oder das von einem Lichtbogen über die Stringleitungen ausgesandte hochfrequente elektrische Störspektrum. Das Erfassen der Messwerte der elektrischen Größen erfolgt dabei häufig auf einer den Strings zugekehrten Seite einer in jeder Stromsammeleinheit vorgesehenen Abschlusskapazität, die eine geringe Impedanz für durch einen Lichtbogen verursachte hochfrequente Modulationen des Stroms durch die betroffenen Stringleitungen bereitstellt.

Das bekannte Verfahren und die bekannte Vorrichtung zur Detektion von Lichtbögen in einer Photovoltaikanlage sind bereits im Wesentlichen ungeeignet, um Lichtbögen zu erfassen, die in oder zwischen den Sammelleitungen oder Stromschienen des Wechselrichters oder zwischen den Sammelleitungen oder Stromschienen des Wechselrichters und Erde auftreten, da sich diese nicht signifikant auf die an den Stringleitungen gemessenen elektrischen Größen auswirken, insbesondere wenn sie auf einer dem Wechselrichter zugekehrten Seite der jeweiligen Abschlusskapazität auftreten. Eine Verlagerung der Messung der elektrischen Größen zu dem Wechselrichter hin würde dieses Problem jedoch nicht lösen, da dort nicht nur die durch einen Lichtbogen im Bereich der Stringleitungen, sondern auch die durch einen Lichtbogen im weiter von dem Wechselrichter entfernten Bereich der Sammelleitungen verursachten Spannungs- und Stromsprünge relativ zur Nennspannung und zum Nennstrom sehr klein bleiben können. Bei der Detektion von Lichtbögen aufgrund des von ihnen ausgesandten hochfrequenten elektrischen Störspektrums besteht die Herausforderung hier darin, das hochfrequente Signal von den häufig sehr hohen Gleichströmen zu trennen. Dafür geeignete Auskopplungsmittel in Form von Drosseln und Übertragern werden bei großen DC-Strömen schnell unverhältnismäßig groß und teuer. Zusätzlich werden durch solche Auskopplungsmittel unerwünschte elektrische Verluste verursacht. Hinzu kommt, dass auch dann, wenn geeignete Auskopplungsmittel in Form von Drosseln und Übertragern bei den in den Sammelleitungen fließenden DC-Strömen noch mit vertretbarem Aufwand realisierbar sind, das zu detektierende hochfrequente Signal des elektrischen Störspektrums auf der dem Wechselrichter zugewandten Seite der Abschlusskapazität aufgrund der im Allgemeinen hohen Induktivität der Sammelleitungen stark gedämpft ist. Die Detektion eines derart gedämpften Signales ist aufgrund des niedrigen Signal/Rausch-Verhältnisses nur schwer möglich und die Aussagekraft einer nachgeschalteten aufwändig zu gestaltenden Auswerteelektronik nur wenig verlässlich.

Aus der DE 196 17 243 A1 sind ein Verfahren und eine Vorrichtung zur Messung des Abstands eines Kabelfehlers, an dem ein Lichtbogen brennt, von einer Schalt- oder Messstation in einem Mittelspannungsnetz bekannt. Dabei werden die Laufzeiten der vom Lichtbogen erzeugten elektrischen und/oder akustischen Signale im Kabel in den Kabelabschnitten beiderseits des Lichtbogens gemessen und daraus die Abstände der Fehlerquelle zu den Enden des Kabelabschnitts berechnet. Das heißt, es werden die von dem Lichtbogen selbst erzeugten Signale ausgenutzt. Dabei handelt es sich sowohl um elektrische Impulse als auch um Körperschallsignale mit einem rein zufälligen Signalverlauf. Der Verlauf der vom Lichtbogen erzeugten Signale wird mit einem Sensor gemessen und nach der Umformung mit einem schnellen Analog-Digital-Wandler als digitales Signal in einem Speicher abgelegt. Durch Filterung mit einer "Fast Fourier Transformation" und einer Korrelationsanalyse ist es möglich, den exakten Zeitpunkt des Eintreffens des vom Lichtbogen in Richtung Sensor ausgesandten Signals zu bestimmen. Zur Erfassung des Körperschalls als Indiz für einen Lichtbogen wird ein piezokeramischer Schallwandler verwendet.

Aus der EP 1 623 240 B1 ist es bekannt, dass Teilentladungsaktivitäten innerhalb einer Isolation von Hochspannungsleitern durch unterschiedliche Methoden, einschließlich chemischer, akustischer und elektrischer Methoden, nachgewiesen werden können. Gelehrt wird konkret die Verwendung von Sensoren zur Detektion von Teilentladungen auf elektrischem Weg, die als kapazitive, induktive oder Längsspannungs-Sensoren ausgebildet sind.

Aus der DE 10 2010 026 815 A1 sind ein Verfahren und eine Vorrichtung zur Ortung von Fehlern in Kabeln bekannt, die insbesondere zur Übertragung und Verteilung von elektrischer Energie dienen und im Erdreich verlegt sind. Genutzt wird ein an einem Fehlerort des Kabels erzeugtes akustisches Signal, das insbesondere ein durch einen elektrischen Impuls ausgelöstes Überschlags- oder Entladungsgeräusch ist. Um dabei den Einfluss von überlagerten Störgeräuschen zu verringern, die eine Identifizierung des akustischen Signals und somit auch eine Lokalisierung des Fehlerorts erschweren, wird ein Empfangssignal, das das am Fehlerort erzeugte akustische Signal beinhaltet, mit gespeicherten Signalmustern oder Merkmalen oder Merkmalsätzen von an einem Fehlerort erzeugten akustischen Signalen verglichen, um das Signal bei einer Übereinstimmung oder einer vorbestimmten Ähnlichkeit mit den Signalmustern oder Merkmalen oder Merkmalsätzen zu identifizieren.

Aus der US 2008/0147335 A1 sind ein Verfahren mit den Merkmalen des Oberbegriffs des unabhängigen Patentanspruchs 1 und eine Detektionsvorrichtung mit den Merkmalen des Oberbegriffs des unabhängigen Patentanspruchs 7 bekannt. Konkret ist eine Mehrzahl von Überwachungsmodulen für eine Mehrzahl von Leistungsquellen vorgesehen, wobei jede der Leistungsquellen einen String von Photovoltaikmodulen umfassen kann. In jedem Überwachungsmodul ist ein Detektor für breitbandiges Rauschen implementiert. Wenn der Detektor für breitbandiges Rauschen Rauschen oberhalb eines Grenzwerts detektiert, sendet er eine Unterbrechungsmitteilung. Diese Einrichtung ist vorgesehen, um einen Lichtbogen zu identifizieren, der durch eine offene Verbindung in dem System aufgrund der relativ hohen Systemspannung verursacht werden kann und der als breitbandiges Rauschen detektiert wird.

Aus der US 2011/0267721 A1 ist ein Verfahren zum Detektieren eines Lichtbogens durch Ultraschall bekannt. Das Verfahren umfasst das Messen mindestens eines Parameters aus der Gruppe der Signalamplitude, der Signaldauer und der zentralen Frequenz des Signals, das von einem Ultraschallsensor empfangen wird. Der Messwert des Parameters wird mit vorgegebenen Werten verglichen, um zu bestimmen, ob der Messwert demjenigen eines Lichtbogens entspricht. Der Ultraschallsensor ist an einem Photovoltaikmodul vorgesehen, wobei insbesondere ist mindestens ein Ultraschallsensor für jeweils zwei Photovoltaikmodule vorgesehen ist. Eine Sicherheitseinrichtung, deren Funktion es ist, den elektrischen Kreis in dem Fall zu öffnen, dass ein Lichtbogen detektiert wird, ist an einem Ausgangsanschluss des Arrays von Photovoltaikmodulen der Photovoltaikanlage vorgesehen oder direkt an allen oder einigen der Photovoltaikmodule. Als Stand der Technik erwähnt die US 2011/0267721 A1, dass Sicherheitssysteme zum Detektieren von möglichen Lichtbögen bekannt sind, die an elektrischen Verbindungen zwischen einem Feld von Photovoltaikmodulen und einem Wechselrichter auftreten. Diese Systeme werden als unzureichend bezeichnet, weil ein Lichtbogen in einem Photovoltaikmodul selbst auftreten kann. Dieses Problem soll durch die Ultraschallsensoren an den Photovoltaikmodulen gelöst werden.

### AUFGABE DER ERFINDUNG

Der Erfindung liegt die Aufgabe zugrunde, ein Verfahren zum Detektieren von Lichtbögen in einer Photovoltaikanlage und eine Detektionsvorrichtung aufzuzeigen, mit denen eine vollständige Überwachung des DC-Bereichs einer Photovoltaikanlage auf das Auftreten von Lichtbögen mit vertretbarem Aufwand realisiert wird.

### LÖSUNG

Erfindungsgemäß wird die Aufgabe durch ein Verfahren mit den Merkmalen des unabhängigen Patentanspruchs 1 und durch Detektionsvorrichtungen mit den Merkmalen der unabhängigen Patentansprüche 7 und 8 gelöst. Bevorzugte Ausführungsformen des erfindungsgemäßen Verfahrens sind in den abhängigen Patentansprüchen 2 bis 6 beschrieben. Die abhängigen Patentansprüche 9 bis 14 betreffen bevorzugte Ausführungsformen der erfindungsgemäßen Detektionsvorrichtungen. Patentanspruch 15 ist auf eine Photovoltaikanlage mit einer erfindungsgemäßen Detektionsvorrichtung gerichtet.

### BESCHREIBUNG DER ERFINDUNG

Das erfindungsgemäße Verfahren zum Detektieren von Lichtbögen in einer Photovoltaikanlage mit einem Wechselrichter und mit mehreren, über Sammelleitungen an den Wechselrichter parallel angeschlossenen Stromsammeleinheiten, wobei an jede Stromsammeleinheit mehrere Strings von Photovoltaikmodulen über Stringleitungen parallel angeschlossen sind, weist ein Erfassen von Messwerten elektrischer Größen (i) an mindestens einer der Stringleitungen jedes Strings und/oder (ii) an mindestens einer Vorsammelleitung jedes Paars von Vorsammelleitungen, an das mehrere Strings parallel angeschlossen sind, und/oder (iii) an mindestens einer der Sammelleitungen von jeder Stromsammeleinheit in den Stromsammeleinheiten, ein Erfassen von Messwerten akustischer Größen (iv) an mindestens einer Sammelleitung von jeder Stromsammeleinheit und/oder (v) an mindestens einer dem Wechselrichter zugeordneten Stromsammeischiene, an die eine Sammelleitung von jeder Stromsammeleinheit angeschlossen ist, ein Analysieren sowohl der Messwerte der elektrischen Größen als auch der Messwerte der akustischen Größen auf das Vorliegen von Hinweisen auf einen Lichtbogen in der Photovoltaikanlage und ein Generieren eines Lichtbogensignals, das das Vorhandensein eines Lichtbogens in der Photovoltaikanlage anzeigt, wenn die vorliegenden Hinweise auf den Lichtbogen vorgegebene Kriterien erfüllen, auf.

Das Erfassen der Messwerte der akustischen Größen an der mindestens einen dem Wechselrichter zugeordneten Sammelschiene und/oder an einer der Sammelleitungen von jeder Stromsammeleinheit kann zentral am Ort des Wechselrichters, insbesondere im Gehäuse des Wechselrichters erfolgen. Es ist jedoch auch möglich, die Erfassung der Messwerte der akustischen Größen an der zumindest einen Sammelleitung von jeder Stromsammeleinheit nahe bei, insbesondere innerhalb des Gehäuses der Stromsammeleinheit durchzuführen. Wenn eine Erfassung der Messwerte der akustischen Größen an der zumindest einen Sammelleitung von jeder Stromsammeleinheit in oder nahe dem Wechselrichter erfolgt, kann eine zusätzliche Erfassung der Messwerte der akustischen Größen an der zumindest einen dem Wechselrichter zugeordneten Stromsammelschiene häufig entfallen, weil dann ein akustisches Signal, welches beispielsweise in der Stromsammelschiene erzeugt wird, in ausreichender Stärke auch an den an dieser Stromsammelschiene angeschlossenen Sammelleitungen erfasst wird. Natürlich ist es auch möglich - und insbesondere im Hinblick auf eine möglichst genaue Lokalisierung des Lichtbogens innerhalb der Photovoltaikanlage auch vorteilhaft - die Messwerte der akustischen Größen sowohl in jeder der dem Wechselrichter zugeordneten Sammelschienen, als auch in allen Sammelleitungen von jeder Stromsammeleinheit zu erfassen.

Zusätzlich zu dem Erfassen von Messwerten elektrischer Größen an den Stringleitungen oder an den nur optional zwischen den Stringleitungen und den Sammelleitungen vorhandenen Vorsammelleitungen, an die mehrere Strings parallel angeschlossen sind, oder an den Sammelleitungen in den Stromsammeleinheiten erfolgt also das Erfassen von Messwerten akustischer Größen, d. h. von anderen Größen. Wenn die akustischen Größen in dem Wechselrichter erfasst werden, werden diese anderen Größen zusätzlich an anderer Stelle erfasst als die elektrischen Größen. Akustische Größen, mit denen eine Überwachung auf Lichtbögen durchführbar ist, sind angesichts der dort fließenden großen Ströme in dem Wechselrichter leichter zu erfassen als elektrische Größen und insbesondere ohne Beeinträchtigung durch die fließenden großen Ströme und unabhängig von der aktuellen Stromstärke dieser Ströme. Bei großen fließenden Strömen ist das Erfassen der Messwerte der akustischen Größen aber nicht nur einfacher als ein Erfassen von Messwerten elektrischer Größen, sondern die Messwerte der akustischen Größen sind auch einfacher auf das Vorliegen von Hinweisen auf einen Lichtbogen in der Photovoltaikanlage hin zu analysieren, weil sie nicht wie die Messwerte der elektrischen Größen durch einen sehr hohen aussagelosen DC-Anteil überlagert sind. Die Erfindung geht daher von der Erkenntnis aus, dass insbesondere für Leitungen, in denen hohe DC-Ströme fließen, eine Lichtbogenüberwachung effizienter und einfacher durch die Erfassung der durch den Lichtbogen erzeugten akustischer Größen, als durch die Erfassung seiner elektrischer Größen durchgeführt werden kann. Dies schließt jedoch nicht aus, dass es Leitungen gibt, bei denen sowohl eine Erfassung der akustischen als auch der elektrischen Größen zur Lichtbogenüberwachung zielführend und auch aufwandsmäßig vertretbar ist. Tendenziell zeigt sich jedoch, dass eine Lichtbogenüberwachung an einer Leitung auf Basis der Erfassung der vom Lichtbogen erzeugten akustischen Größen mit zunehmender Stromstärke innerhalb der Leitung gegenüber einer Erfassung auf Basis der von dem Lichtbogen erzeugten elektrischen Größen vorteilhafter wird.

Bei den akustischen Größen, deren Messwerte erfasst werden, handelt es sich um Frequenz und/oder Amplitude von Schallschwingungen. Lichtbögen regen solche Schallschwingungen in charakteristischer Weise an. Bei dem Schall kann es sich insbesondere um Körperschall, grundsätzlich aber auch um Luftschall handeln. Wenn Luftschall in dem Wechselrichter oder in einer Stromsammeleinheit gemessen wird, erfolgt dies vorzugsweise so, dass nicht nur der Luftschall in dem Wechselrichter oder der Stromsammeleinheit selbst, sondern auch aus der Umgebung auf den Wechselrichter oder die Stromsammeleinheit einfallender Luftschall erfasst wird.

Darüber hinaus stellt sich heraus, dass die Messwerte der akustischen Größen, zumindest dann, wenn die akustischen Größen Frequenz und/oder Amplitude von Körperschallschwingungen umfassen, die von den Sammelleitungen ausgehen, diese Sammelleitungen auch über längere Strecken, über die sie sich zwischen der jeweiligen Stromsammeleinheit und dem Wechselrichter erstrecken können, zuverlässig auf das Auftreten von Lichtbögen überwacht werden können. Übliche Sammelleitungen weisen eine ausreichend hohe Leitfähigkeit für Körperschall auf, während sie für die relevanten Informationen elektrischer Größen beispielsweise aufgrund ihrer Leitungsinduktivität häufig eine hohe Dämpfung zeigen.

Konkret können bei dem erfindungsgemäßen Verfahren die akustischen Größen, deren Messwerte an den Sammelleitungen und/oder an der oder den Stromsammelschiene(n) erfasst werden, Frequenz und/oder Amplitude von Körperschallschwingungen der jeweiligen Sammelleitung oder Stromsammelschiene umfassen.

Grundsätzlich können die Körperschallschwingungen aller Sammelleitungen und beider Stromsammelschienen erfasst werden. Bei der Erfassung der Körperschallschwingungen der Stromsammelschienen werden bei einer vorhandenen mechanischen Kopplung auch Körperschallschwingungen der daran angeschlossenen Sammelleitungen erfasst. So kann, wenn nur die Körperschallschwingungen der Stromsammelschienen erfasst werden, der Erfassungsaufwand insgesamt sehr klein gehalten werden. Hingegen kann mit Hilfe der Erfassung der Körperschallschwingungen der Sammelleitungen eine Lokalisierung eines detektierten Lichtbogens auf die Sammelleitung von einer bestimmten Stromsammeleinheit erfolgen, und dabei werden wegen der mechanischen Kopplungen auch Körperschallschwingungen der Stromsammelschienen erfasst. Um eine redundante Detektion auf das Auftreten von Lichtbögen einzurichten, können sowohl an allen Sammelleitungen als auch an beiden Stromsammelschienen die jeweiligen Körperschallschwingungen erfasst werden.

Die elektrischen Größen, deren Messwerte bei dem erfindungsgemäßen Verfahren in den Stromsammeleinheiten erfasst werden, können Frequenz und/oder Amplitude von Strömen durch die jeweilige Stringleitung oder Vorsammelleitung oder Sammelleitung und/oder Frequenz und/oder Amplitude von Spannungen zwischen den jeweiligen Stringleitungen oder Vorsammelleitungen oder Sammelleitungen und/oder Frequenz und/oder Amplitude von Spannungen zwischen einer der jeweiligen Stringleitungen Vorsammelleitungen oder Sammelleitungen und Erde umfassen. Die Kriterien können hier das Auftreten von Sprüngen bei den DC-Anteilen der Ströme oder Spannungen oder hochfrequente AC-Anteile bei den Strömen oder Spannungen sein.

Die Messwerte der elektrischen Größen werden vorzugsweise auf einer den Strings zugekehrten Seite einer zwischen den Stringleitungen wirksamen Abschlusskapazität erfasst. Die Abschlusskapazität stellt eine definierte niedrige Impedanz für das hochfrequente Störsignal eines Lichtbogens dar, der in einem der Strings oder im Bereich dessen Stringleitungen brennt. Die Abschlusskapazität kann dabei zwischen die Stringleitungen jedes Strings und/oder zwischen jedes Paar von Vorsammelleitungen geschaltete Kondensatoren und/oder einen oder mehrere zwischen die Sammelleitungen geschaltete Kondensatoren umfassen. Bei einer mit einem oder mehreren Kondensatoren zwischen den Sammelleitungen bereitgestellten Abschlusskapazität ist es ausreichend, die Messwerte der elektrischen Größen in der jeweiligen Sammeleinheit nur an den Sammelleitungen zu erfassen. Eine stringweise Auskopplung hochfrequenter Störsignale ist auch möglich und im Hinblick auf eine bessere Lokalisierung eines Lichtbogens auch vorteilhaft, aber mit größerem Aufwand und entsprechend höheren Kosten verbunden.

Bei dem erfindungsgemäßen Verfahren können die vorgegebenen Kriterien, mit denen vorliegende Hinweise auf einen Lichtbogen verglichen werden, eine Kombination von Hinweisen auf den Lichtbogen bei den Messwerten der elektrischen Größen und den Messwerten der akustischen Größen umfassen. Das heißt, ein Lichtbogen kann nicht nur dadurch detektiert werden, dass die Hinweise bei den Messwerten der elektrischen Größen oder die Hinweise bei den Messwerten der akustischen Größen die vorgegebenen Kriterien erfüllen. Ein Lichtbogen kann auch dadurch detektiert werden, wenn die Hinweise bei den Messwerten der elektrischen Größen und den Messwerten der akustischen Größen jeweils nur schwächere und als solche nicht ausreichende Kriterien erfüllen, aber in ihrer Summe doch als ausreichend für das Vorhandensein eines Lichtbogens anzusehen sind. Hierbei ist es vorteilhaft, eine zeitliche Korrelation zwischen Messwerten der elektrischen und der akustischen Größen - beispielweise über Zeitstempel der jeweiligen Messwerte - herzustellen. Die Zeitstempel geben den Zeitpunkt der Erfassung der jeweiligen Messwerte an. Ein Lichtbogen sendet ab dem Moment seines Entstehens sowohl elektrische als auch akustische Größen bzw. Signale aus. Wegen ihrer hohen Ausbreitungsgeschwindigkeit werden die elektrischen Signale am Ort entsprechender elektrischer Sensoren - insbesondere Stromsensoren und/oder Spannungssensoren - praktisch zeitgleich mit ihrer gegebenenfalls an einem anderen Ort erfolgenden Erzeugung wahrgenommen. Bei den akustischen Signalen ist dies wegen ihrer viel geringeren Ausbreitungsgeschwindigkeit nicht der Fall, auch wenn die Ausbreitungsgeschwindigkeit von Körperschall in der Regel deutlich über derjenigen von Luftschall liegt. Die Erfassung der Messwerte der akustischen Größen erfolgt daher prinzipiell erst mit einem signifikanten Zeitversatz nach deren Entstehung, der vom Ort des Lichtbogens und dem Ort der akustischen Sensoren abhängt. Werden nun die Messwerte sowohl der akustischen, als auch der elektrischen Größen mit Zeitstempeln versehen, so ermöglicht der Vergleich der Messwerte der elektrischen und akustischen Größen nicht nur eine zusätzliche Plausibilisierung für den Lichtbogen, sondern auch eine genauere Lokalisierung des Lichtbogens bis hin auf einen bestimmten Abschnitt der betreffenden Leitung.

Eine erfindungsgemäße Detektionsvorrichtung für Lichtbögen in einer Photovoltaikanlage mit einem Wechselrichter und mit mehreren, über Sammelleitungen an den Wechselrichter parallel angeschlossenen Stromsammeleinheiten, wobei an jede Stromsammeleinheit mehrere Strings von Photovoltaikmodulen über Stringleitungen parallel angeschlossen sind, weist in jeder Stromsammeleinheit mindestens einen elektrischen Sensor, der Messwerte elektrischer Größen an mindestens einer der Stringleitungen jedes Strings und/oder an mindestens einer Vorsammelleitung jedes Paars von Vorsammelleitungen, an das mehrere Strings parallel angeschlossen sind, und/oder an mindestens einer der Sammelleitungen von jeder Stromsammeleinheit erfasst, mindestens einen akustischen Sensor, der Messwerte akustischer Größen an mindestens einer Sammelleitung von jeder Stromsammeleinheit und/oder an mindestens einer dem Wechselrichter zugeordneten Stromsammelschiene, an die eine Sammelleitung von jeder Stromsammeleinheit angeschlossen ist, erfasst, und mindestens eine Analyseeinrichtung auf, an die zumindest alle in einer Stromsammeleinheit vorhandenen Sensoren angeschlossen sind. An die mindestens eine Analyseeinrichtung können alle elektrischen und akustischen Sensoren angeschlossen sein, und sie kann dazu ausgebildet sein, die Messwerte der elektrischen Größen und die Messwerte der akustischen Größen auf das Vorliegen von Hinweisen auf einen Lichtbogen in der Photovoltaikanlage zu analysieren und ein Lichtbogensignal zu generieren, das das Vorhandensein eines Lichtbogens in der Photovoltaikanlage anzeigt, wenn die vorliegenden Hinweise auf den Lichtbogen vorgegebene Kriterien erfüllen.

Es können auch mehrere getrennte Analyseeinrichtungen vorgesehen sein, wobei an eine Analyseeinrichtung in jeder Sammeleinheit die elektrischen Sensoren angeschlossen sind und an eine weitere Analyseeinrichtung der mindestens eine akustische Sensor. Entsprechend analysiert dann die Analyseeinrichtung in jeder Sammeleinheit nur die Messwerte der elektrischen Größen aus jeder Sammeleinheit auf das Vorliegen von Hinweisen auf einen Lichtbogen, während die beispielsweise in dem Wechselrichter angeordnete weitere Analyseeinrichtung die Messwerte der akustischen Größen analysiert. Ein Lichtbogensignal, das das Vorhandensein eines Lichtbogens in der Photovoltaikanlage anzeigt, wird dann von jeder der Analyseeinrichtungen generiert, wenn die ihr vorliegenden Hinweise auf den Lichtbogen die vorgegebenen Kriterien erfüllen.

Wenn jedoch eine gemeinsame Analyseeinrichtung vorgesehen ist, um die Messwerte der elektrischen Größen und die Messwerte der akustischen Größen zu analysieren, kann die Analyseeinrichtung auch dazu ausgebildet sein, das Lichtbogensignal zu generieren, wenn die vorliegenden Hinweise auf den Lichtbogen vorgegebene Kriterien erfüllen, die eine Kombination von Hinweisen auf den Lichtbogen bei den Messwerten der elektrischen Größen und den Messwerten der akustischen Größen umfassen. Eine gemeinsame Analyseeinrichtung ist insbesondere dann vorteilhaft, wenn die Messwerte der akustischen und/oder der elektrischen Größen von den sie erfassenden Sensoren mit Zeitstempeln versehen werden, die den Zeitpunkt ihrer Erfassung angeben, und diese Zeitstempel zusätzlich zu den eigentlichen Messwerten der akustischen und elektrischen Größen analysiert werden, beispielsweise im Hinblick auf eine zusätzliche Plausibilisierung oder eine ortsgenauere Lokalisierung des Lichtbogens.

Bei der erfindungsgemäßen Detektionsvorrichtung ist der mindestens eine akustische Sensor insbesondere ein Körperschallsensor. Wenn tatsächlich nur ein einziger akustischer Sensor vorgesehen ist, erfasst dieser Frequenz und/oder Amplitude von Körperschallschwingungen der Stromsammeischiene, an die eine Sammelleitung von jeder Stromsammeleinheit in dem Wechselrichter angeschlossen ist. Alternativ oder zusätzlich können akustische Sensoren in Form von Körperschallsensoren bei der erfindungsgemäßen Vorrichtung die Frequenz und/oder Amplitude von Körperschallschwingungen der mindestens einen Sammelleitung von jeder Stromsammeleinheit erfassen.

Der mindestens eine elektrische Sensor der erfindungsgemäßen Detektionsvorrichtung kann einen Stromsensor, der Frequenz und/oder Amplitude von Strömen durch die jeweilige Stringleitung oder Vorsammelleitung oder Sammelleitung erfasst, und/oder einen Spannungssensor umfassen, der Frequenz und/oder Amplitude von Spannungen zwischen den jeweiligen Stringleitungen oder Vorsammelleitungen oder Sammelleitungen und/oder Frequenz und/oder Amplitude von Spannungen zwischen einer der jeweiligen Stringleitungen Vorsammelleitungen oder Sammelleitungen und Erde erfasst. Gleichfalls ist es möglich, dass der mindestens eine Spannungssensor Frequenz und/oder Amplitude von Spannungen zwischen einer Stringleitung, einer Vorsammelleitung oder einer Sammelleitung und Erde erfasst.

Eine erfindungsgemäße Photovoltaikanlage mit einem Wechselrichter, mit mehreren, über Sammelleitungen an den Wechselrichter parallel angeschlossenen Stromsammeleinheiten, wobei an jede Stromsammeleinheit mehrere Strings von Photovoltaikmodulen über Stringleitungen parallel angeschlossen sind, weist weiterhin eine erfindungsgemäße Detektionsvorrichtung auf.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere der dargestellten relativen Anordnung und Wirkverbindung mehrerer Bauteile - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Verfahren, die jeweilige Detektionsvorrichtung oder Photovoltaikanlage besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand eines in der Figur dargestellten bevorzugten Ausführungsbeispiels weiter erläutert und beschrieben.

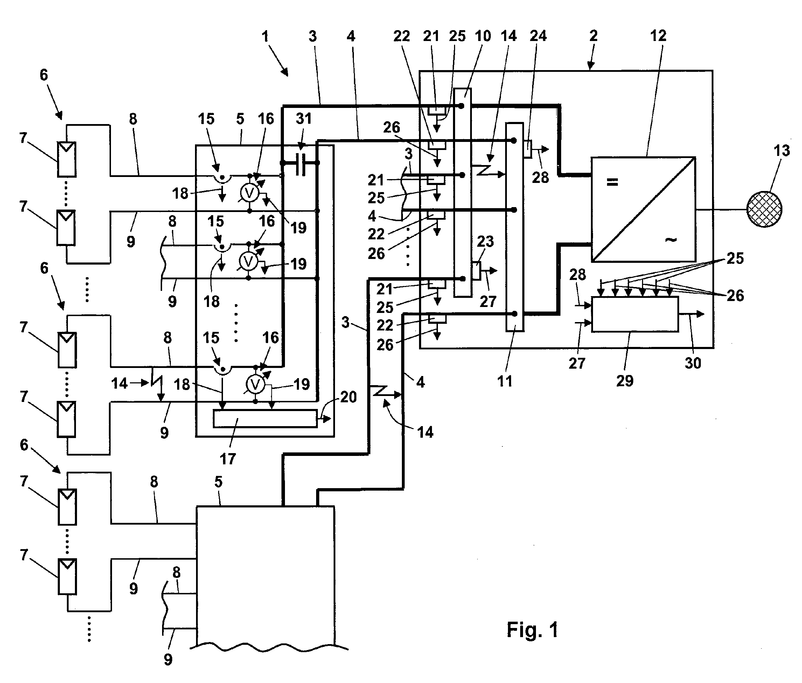

- **Fig. 1**: zeigt schematisch eine erfindungsgemäße Photovoltaikanlage mit einer erfindungsgemäßen Detektionseinrichtung für Lichtbögen in der Photovoltaikanlage.

### FIGURENBESCHREIBUNG

Bei der in **Fig. 1** schematisch dargestellten Photovoltaikanlage 1 sind viele Details einer Photovoltaikanlage, die dem Fachmann geläufig sind, die für die vorliegende Erfindung aber von keiner besonderen Bedeutung sind, nicht dargestellt. Hierzu zählen beispielsweise typischerweise vorhandene Schalter und Sicherungen. Weiterhin sind Bestandteile der Photovoltaikanlage, die mehrfach in ähnlicher oder sogar gleicher Weise vorhanden sind, in ihrer Mehrzahl nur angedeutet. Insbesondere ist die Zahl dieser mehrfach vorhandenen Komponenten der Photovoltaikanlage 1 aus der Figur nicht zu entnehmen. So kann eine in Fig. 1 angedeutete Mehrzahl einer Komponente viel größer sein als eine angedeutete Mehrzahl einer anderen Komponente, ohne dass dies aus der Figur ersichtlich ist.

Die Photovoltaikanlage 1 gemäß Fig. 1 weist einen Wechselrichter 2 auf. An den Wechselrichter 2 sind über jeweils ein Paar von Sammelleitungen 3, 4 mehrere Stromsammeleinheiten 5 parallel angeschlossen. An jede Stromsammeleinheit 5 sind mehrere Strings 6 mit in Reihe geschalteten Photovoltaikmodulen 7 über Paare von Stringleitungen 8 und 9 parallel angeschlossen. In den Stromsammeleinheiten 5 sind die jeweiligen Stringleitungen 8 mit der jeweiligen Sammelleitung 3 und die jeweiligen Stringleitungen 9 mit der jeweiligen Sammelleitung 4 verbunden. Dabei können hier nicht dargestellte Schalter vorgesehen sein, um die Stringleitungen 8, 9 z. B. paarweise den Sammelleitungen 3, 4 zuzuschalten. In dem Wechselrichter 2 sind in entsprechender Weise die Sammelleitungen 3 von den einzelnen Stromsammeleinheiten 5 mit einer Stromsammelschiene 10 und die Sammelleitungen 4 von den Stromsammeleinheiten 5 mit einer Stromsammelschiene 11 verbunden. An die Stromsammelschienen 10 und 11 ist ein DC/AC-Wandler 12 angeschlossen, der den von den Photovoltaikmodulen 7 generierten Gleichstrom in einen Wechselstrom umrichtet, den er beispielsweise in ein Wechselstromnetz 13 einspeist. Statt nur eines DC/AC-Wandlers können auch mehrere DC/AC-Wandler parallel an die Stromschienen 10 und 11 angeschlossen sein, beispielsweise ein DC/AC-Wandler je Phase eines in das Wechselstromnetz 13 eingespeisten dreiphasigen Wechselstroms. Die Zahl der Stromsammeleinheiten 5 ist typischerweise kleiner als die Zahl der Strings 6 je Stromsammeleinheit 5. Dies muss aber nicht so sein. Diese Zahlen können auch gleich sein, oder es können auch mehr Stromsammeleinheiten 5 als Strings 6 pro Stromsammeleinheit 5 vorgesehen sein.

In der in Fig. 1 beispielhaft dargestellten Photovoltaikanlage 1 sind keine DC/DC-Wandler zwischen den Strings 6 und dem DC/AC-Wandler 12 vorhanden. Aufgrund dessen treten grundsätzlich gleiche Spannungen zwischen jedem Paar von Stringleitungen 8 und 9, jedem Paar von Sammelleitung 3 und 4 und den Stromsammelschienen 10 und 11 auf. Jedoch wachsen mit jeder Parallelschaltung von Strings 6 und Stromsammeleinheiten 5 die Stromstärken an. Das Risiko, dass bei Isolationsfehlern zwischen Leitern oder gegenüber Erde Lichtbögen 14 in der Photovoltaikanlage 1 auftreten, ist durch die überall gleich große und typischerweise einige hundert bis wenige tausend Volt betragende Spannung überall gegeben. Neben den voranstehend beschriebenen und in Fig. 1 konkret dargestellten Lichtbögen 14, die auch als Parallel-Lichtbögen bezeichnet werden, besteht auch ein Risiko von (in Fig. 1 nicht dargestellten) Serien-Lichtbögen innerhalb eines Leiters, z. B. innerhalb einer Stringleitung 8, 9 oder einer Sammelleitung 3, 4. Das Detektieren jeglicher Lichtbögen 14, d. h. sowohl von Parallel- als auch Serienlichtbögen, im Bereich jedes Paars von Stringleitungen 8 und 9 erfolgt mit Hilfe eines Stromsensors 15 und eines Spannungssensors 16, der hier für die Stringleitungen 8 und 9 jedes Strings 6 vorgesehen ist. Es reicht jedoch auch ein Stromsensor 15 und/oder ein Spannungssensors 16 für jedes von mehreren Paaren von optionalen (und in Fig. 1 nicht dargestellten) Vorsammelleitungen, an die jeweils mehrere Strings 6 angeschlossen sind und die parallel an die Sammelleitungen 3, 4 angeschlossen sind, oder selbst ein Stromsensor 15 und/oder ein Spannungssensors 16 für die Sammelleitungen 3, 4 von jeder Stromsammeleinheit 5. In jedem Fall sind alle Stromsensoren 15 und Spannungssensoren 16 auf einer den Strings zugekehrten Seite einer Abschlusskapazität 31 in der jeweiligen Stromsammeleinheit 5 angeordnet, die durch einen zwischen die Sammelleitungen 4 und 5 geschalteten Kondensator gebildet wird und die für Lichtbögen 14 im Bereich der Strings 6 und ihrer Stringleitungen 8 und 9 eine niedrige Impedanz bereitstellt. Die Stromsensoren 15 und die Spannungssensoren 16 können die von ihnen erfassten Messwerte elektrischer Größen mit Zeitstempeln versehen, die die Zeitpunkte angeben, zu denen die einzelnen Messwerte erfasst wurden.

Beim Auftreten eines Lichtbogens 14 kommt es zu signifikanten Sprüngen beim Strom durch und der Spannung zwischen den Stringleitungen 8 und 9 und/oder zu hochfrequenten Schwankungen des Stroms bzw. der Spannung, die mit dem jeweiligen Stromsensor 15 bzw. Spannungssensor 16 erfasst werden. Die gegebenenfalls mit Zeitstempeln versehenen Messwerte 18 und 19 von den Sensoren 15 und 16 werden in einer Analyseeinrichtung 17 auf das Vorliegen von Hinweisen auf einen Lichtbogen 14 analysiert. Wenn diese Hinweise vorgegebene Kriterien erfüllen, wird von der Analyseeinrichtung 17 ein Lichtbogensignal 20 ausgegebenen. Das Lichtbogensignal 20 kann Maßnahmen zum Löschen des Lichtbogens einleiten und/oder einen Warnhinweis an den Betreiber der Photovoltaikanlage 1 geben.

Mit den Sensoren 15 und 16 und der Analyseeinrichtung 17 werden jedoch Lichtbögen 14 im hinter den Abschlusskapazitäten 31 liegenden Bereich der Sammelleitungen 3 und 4 und der Sammelschienen 10 und 11 nicht zuverlässig detektiert. Hier könnten zwar auch grundsätzlich elektrische Größen gemessen werden, um etwaige Lichtbögen 14 zu detektieren. Dies erweist sich jedoch wegen der hier zunehmenden Stromstärke als zunehmend aufwändig, weil die Hinweise auf das Vorliegen eines Lichtbogens bei den Messwerten der elektrischen Größen hier mit relativ höheren DC-Pegeln überlagert sind. Zudem dämpfen die mitunter hohen Leitungsinduktivitäten der Sammelleitungen 3, 4 die von Lichtbögen ausgehenden hochfrequenten elektrischen Signale sehr stark. Zur Detektion etwaiger Lichtbögen 14 sind daher Körperschallsensoren 21 und 22 an den Sammelleitungen 3 und 4 sowie Körperschallsensoren 23 und 24 an den Stromsammelschienen 10 und 11 vorgesehen. Die Körperschallsensoren 21 bis 24 sind bei der in Fig. 1 dargestellten Ausführungsform sämtlich in dem Wechselrichter 2 angeordnet. Zumindest die Körperschallsensoren 21 und 22 könnten jedoch vorteilhafterweise auch in den Stromsammeleinheiten 5 angeordnet sein, weil es dort im Vergleich zum Inneren des Wechselrichters 2 wegen weniger Störgeräuschen in der Regel leiser ist. Die Körperschallsensoren 21 bis 24 können die von ihnen erfassten Messwerte akustischer Größen mit Zeitstempeln versehen, die die Zeitpunkte angeben, zu denen die einzelnen Messwerte erfasst wurden.

Die Körperschallsensoren 21 und 22 erfassen unmittelbar Körperschallschwingungen der Sammelleitungen 3 und 4 und geben Messwerte 25 und 26 zu Frequenz und Amplitude dieser Körperschallschwingungen aus, die gegebenenfalls mit Zeitstempeln versehen sind. Die Körperschallsensoren 23 und 24 erfassen Körperschallschwingungen der Stromsammelschienen 10 und 11 und damit indirekt auch Körperschallschwingungen der Sammelleitungen 3 und 4 und geben Messwerte 27 und 28 aus, die Frequenz und Amplitude der Körperschallschwingungen der Stromsammelschienen 10 und 11 anzeigen. Die Messwerte 25 bis 28 werden von einer Analyseeinrichtung 29 analysiert, die dann, wenn Hinweise auf einen Lichtbogen 14 vorgegebene Kriterien erfüllen, ein Lichtbogensignal 30 ausgibt. Die Detektionsvorrichtung für Lichtbögen in der Photovoltaikanlage 1 umfasst somit die Sensoren 15 und 16 sowie die Analyseeinrichtung 17 in den einzelnen Stromsammeleinheiten 5 und die Körperschallsensoren 21 bis 24 und die Analyseeinrichtung 29. Bei der in Fig. 1 dargestellten Ausführungsform befinden sich die Körperschallsensoren 21 bis 24 und die Analyseeinrichtung 29 in dem Wechselrichter 2. Prinzipiell ist jedoch die dargestellte örtliche Zuordnung der Körperschallsensoren 21 bis 24 wie auch der Analyseeinrichtungen 17 und 29 nur beispielhaft und nicht limitierend zu verstehen. Beispielsweise können einzelne oder auch alle der Körperschallsensoren 21, 22 für die Sammelleitungen 3, 4 in den entsprechenden Stromsammeleinheiten 5 angeordnet sein. Bei der in Fig. 1 dargestellten Ausführungsform unterscheiden sich die einzelnen Sensoren nicht nur bezüglich ihres Ortes, sondern auch bezüglich der Größen, zu denen sie Messwerte erfassen.

Wenn es nur um Lichtbögen 14 zwischen den Sammelleitungen 3 und 4 geht und Lichtbögen von einzelnen Sammelleitungen 3 und 4 gegen Erde sowie Serien-Lichtbögen innerhalb der Sammelleitungen 3,4 und der Stromsammelschienen 10, 11 ausgeschlossen werden können, muss von den Körperschallsensoren 21 bis 24 nur einer der Körperschallsensoren 23 und 24 vorgesehen sein, und es sind auch nur die Körperschallsensoren 21 oder die Körperschallsensoren 22 ausreichend. Wenn jedoch auch Lichtbögen gegenüber Erde wie auch (Serien-)Lichtbögen innerhalb der Sammelleitungen 3, 4 als auch der Stromsammelschienen 10, 11 detektiert werden sollen, müssen Körperschallsensoren 23, 24 zumindest an beiden Stromsammelschienen 10, 11 oder allen daran angeschlossenen Sammelleitungen 3, 4 vorgesehen werden.

Es erweist sich als vorteilhaft, dass die Körperschallsensoren 21 bis 24 wegen ihres von den elektrischen Größen unabhängigen Messprinzips für ganz unterschiedlich dimensionierte Wechselrichter 2 identisch ausgebildet sein können. Anders gesagt müssen sie nicht für einen für höhere Leistungen ausgelegten Wechselrichter anders ausgelegt werden als für einen für niedrigere Leistungen ausgelegten Wechselrichter 2. Weiterhin erweist es sich, dass die von den Körperschallsensoren 21 bis 24 gelieferten Messwerte 25 bis 28 geeignet sind, sowohl Serien- als auch Parallel-Lichtbögen 14 sicher zu detektieren, und dies auch bei sehr langen Sammelleitungen 3 und 4. In ihrer Gesamtheit ist die Detektionsvorrichtung für Lichtbögen 14 der Photovoltaikanlage 1 gemäß Fig. 1 daher geeignet, an beliebigen Stellen der Photovoltaikanlage 1 auftretende Lichtbögen 14 sicher zu detektieren. Dabei können die Analyseeinrichtungen 17 und 29 auch zusammengefasst sein oder kooperieren, um Lichtbögen 14 sowohl durch Hinweise in den Messwerten 18 und 19 der Sensoren 15 und 16 als auch durch Hinweise in den Messwerten 25 bis 28 von den Körperschallsensoren 21 bis 24 zu erkennen. In diesem Fall können sowohl die Messwerte 18, 19 der elektrischen Größen, die Messwerte 25 bis 28 der akustischen Größen und/oder die Lichtbogensignale 20, 30 über eine nicht näher dargestellte Kommunikationseinrichtung - beispielsweise über Funk - zwischen den Analyseeinrichtungen 17 und 29 oder zwischen den Stromsammeleinheiten 5 und dem Wechselrichter 2 übertragen werden.

Gemäß Fig. 1 wurde die erfindungsgemäßen Detektionseinrichtung für Lichtbögen in einer Photovoltaikanlage am Beispiel einer Photovoltaikanlage 1 erläutert, die keine DC/DC Wandler zwischen den Strings 6 und dem DC/AC-Wandler 12 aufweist, und in der somit grundsätzlich gleiche Spannungen zwischen jedem Paar von Stringleitungen 8 und 9, jedem Paar von Sammelleitungen 3 und 4 und den Stromsammelschienen 10 und 11 auftreten. Die erfindungsgemäße Detektionseinrichtung wie auch das erfindungsgemäße Verfahren ist jedoch nicht auf eine derartige Photovoltaikanlage beschränkt, sondern kann auch bei Photovoltaikanlagen, die einen oder mehrere DC/DC-Wandler zwischen den Strings 6 und dem DC/AC-Wandler 12 aufweisen, angewendet werden. Bei diesen Photovoltaikanlagen können naturgemäß unterschiedliche Spannungen zwischen den Stringleitungen 8 und 9, den Sammelleitungen 3 und 4 bzw. den Stromsammeischienen 10 und 11 herrschen.

### BEZUGSZEICHENLISTE

- 1: Photovoltaikanlage
- 2: Wechselrichter
- 3: Sammelleitung
- 4: Sammelleitung
- 5: Stromsammeleinheit
- 6: String
- 7: Photovoltaikmodul
- 8: Stringleitung
- 9: Stringleitung
- 10: Stromsammelschiene
- 11: Stromsammelschiene
- 12: DC/AC-Wandler
- 13: Wechselstromnetz
- 14: Lichtbogen
- 15: Stromsensor
- 16: Spannungssensor
- 17: Analyseeinrichtung
- 18: Messwerte
- 19: Messwerte
- 20: Lichtbogensignal
- 21: Körperschallsensor
- 22: Körperschallsensor
- 23: Körperschallsensor
- 24: Körperschallsensor
- 25: Messwerte
- 26: Messwerte
- 27: Messwerte
- 28: Messwerte
- 29: Analyseeinrichtung
- 30: Lichtbogensignal
- 31: Abschlusskapazität

## Patentansprüche

1. Verfahren zum Detektieren von Lichtbögen (14) in einer Photovoltaikanlage (1) mit einem Wechselrichter (2) und mit mehreren, über Sammelleitungen (3, 4) an den Wechselrichter (2) parallel angeschlossenen Stromsammeleinheiten (5), wobei an jede Stromsammeleinheit (5) mehrere Strings (6) von Photovoltaikmodulen (7) über Stringleitungen (8, 9) parallel angeschlossen sind,
wobei das Verfahren aufweist:
- Erfassen von Messwerten (18, 19) elektrischer Größen
- an mindestens einer der Stringleitungen (8, 9) jedes Strings (6) und/oder
- an mindestens einer Vorsammelleitung jedes Paars von Vorsammelleitungen, an das mehrere Strings (6) parallel angeschlossen sind, und/oder an mindestens einer der Sammelleitungen (3, 4) von jeder Stromsammeleinheit (5) in den Stromsammeleinheiten (5),
- Analysieren der Messwerte (18, 19) der elektrischen Größen auf das Vorliegen von Hinweisen auf einen Lichtbogen (14) in der Photovoltaikanlage (1),
- Generieren eines Lichtbogensignals (20), das das Vorhandensein eines Lichtbogens (14) in der Photovoltaikanlage (1) anzeigt, wenn die vorliegenden Hinweise auf den Lichtbogen (14) vorgegebene Kriterien erfüllen,
**dadurch gekennzeichnet, dass** das Verfahren weiterhin aufweist:
- Erfassen von Messwerten (25 bis 28) akustischer Größen
- an mindestens einer Sammelleitung (3, 4) von jeder Stromsammeleinheit (5) und/oder
- an mindestens einer dem Wechselrichter (2) zugeordneten Stromsammelschiene, an die eine Sammelleitung (3, 4) von jeder Stromsammeleinheit (5) angeschlossen ist, und
- Analysieren der Messwerte (25 bis 28) der akustischen Größen auf das Vorliegen von Hinweisen auf einen Lichtbogen (14) in der Photovoltaikanlage (1).

2. Verfahren nach Anspruch 1, **dadurch gekennzeichnet, dass** die akustischen Größen Frequenz und/oder Amplitude von Körperschallschwingungen der jeweiligen Sammelleitung (3, 4) oder Stromsammelschiene (10, 11) umfassen.

3. Verfahren nach einem der vorhergehenden Ansprüche, **dadurch gekennzeichnet, dass** die elektrischen Größen, deren Messwerte (18, 19) in den Stromsammeleinheiten (5) erfasst werden,
- Frequenz und/oder Amplitude von Strömen durch die jeweilige Stringleitung (8, 9) oder Vorsammelleitung oder Sammelleitung (3, 4) und/oder
- Frequenz und/oder Amplitude von Spannungen zwischen den jeweiligen Stringleitungen (8, 9) oder Vorsammelleitungen oder Sammelleitungen (3, 4) und/oder
- Frequenz und/oder Amplitude von Spannungen zwischen einer der jeweiligen Stringleitungen (8, 9), Vorsammelleitungen oder Sammelleitungen (3, 4) und Erde umfassen.

4. Verfahren nach Anspruch 3, **dadurch gekennzeichnet, dass** die Messwerte der elektrischen Größen auf einer den Strings (6) zugekehrten Seite einer zwischen den Stringleitungen (8, 9) wirksamen Abschlusskapazität (31) erfasst werden.

5. Verfahren nach einem der vorhergehenden Ansprüche, **dadurch gekennzeichnet, dass** die Messwerte (18, 19) der elektrischen Größen und/oder die Messwerte (25 bis 28) der akustischen Größen mit Zeitstempeln versehen werden, die den Zeitpunkt ihrer Erfassung angeben.

6. Verfahren nach einem der vorhergehenden Ansprüche, **dadurch gekennzeichnet, dass** die vorgegebenen Kriterien eine Kombination von Hinweisen auf den Lichtbogen (14) bei den Messwerten (18, 19) der elektrischen Größen und den Messwerten (25 bis 28) der akustischen Größen umfassen.

7. Detektionsvorrichtung für Lichtbögen (14) in einer Photovoltaikanlage (1) mit einem Wechselrichter (2) und mit mehreren, über Sammelleitungen (3, 4) an den Wechselrichter (2) parallel angeschlossenen Stromsammeleinheiten (5), wobei an jede Stromsammeleinheit (5) mehrere Strings (6) von Photovoltaikmodulen (7) über Stringleitungen (8, 9) parallel angeschlossen sind,
wobei die Detektionsvorrichtung aufweist:
- mindestens einen elektrischen Sensor (15, 16) in jeder Stromsammeleinheit (5), der Messwerte (18, 19) elektrischer Größen
- an mindestens einer der Stringleitungen (8, 9) jedes Strings (6) und/oder
- an mindestens einer Vorsammelleitung jedes Paars von Vorsammelleitungen, an das mehrere Strings (6) parallel angeschlossen sind, und/oder
- an mindestens einer der Sammelleitungen (3, 4) von jeder Stromsammeleinheit (5)
erfasst,
- mindestens eine Analyseeinrichtung (17), an die zumindest alle in einer Stromsammeleinheit (5) vorhandenen elektrischen Sensoren (15, 16) angeschlossen sind und die dazu ausgebildet ist, die Messwerte (18, 19) der elektrischen Größen auf das Vorliegen von Hinweisen auf einen Lichtbogen (14) in der Photovoltaikanlage (1) zu analysieren und ein Lichtbogensignal (20) zu generieren, das das Vorhandensein eines Lichtbogens (14) in der Photovoltaikanlage (1) anzeigt, wenn die vorliegenden Hinweise auf den Lichtbogen (14) vorgegebene Kriterien erfüllen,
**dadurch gekennzeichnet,**
- **dass** die Detektionsvorrichtung weiterhin mindestens einen akustischen Sensor aufweist, der Messwerte (25 bis 28) akustischer Größen
- an mindestens einer Sammelleitung (3, 4) von jeder Stromsammeleinheit (5) und/oder
- an mindestens einer dem Wechselrichter (2) zugeordneten Stromsammelschiene, an die eine Sammelleitung (3, 4) von jeder Stromsammeleinheit (5) angeschlossen ist,
erfasst,
- wobei der mindestens eine akustische Sensor an eine weitere Analyseeinrichtung (29) angeschlossen ist und wobei die weitere Analyseeinrichtung (29) dazu ausgebildet ist, die Messwerte (25 bis 28) der akustischen Größen auf das Vorliegen von Hinweisen auf einen Lichtbogen (14) in der Photovoltaikanlage (1) zu analysieren und ein Lichtbogensignal (30) zu generieren, das das Vorhandensein eines Lichtbogens (14) in der Photovoltaikanlage (1) anzeigt, wenn die vorliegenden Hinweise auf den Lichtbogen (14) vorgegebene Kriterien erfüllen.

8. Detektionsvorrichtung für Lichtbögen (14) in einer Photovoltaikanlage (1) mit einem Wechselrichter (2) und mit mehreren, über Sammelleitungen (3, 4) an den Wechselrichter (2) parallel angeschlossenen Stromsammeleinheiten (5), wobei an jede Stromsammeleinheit (5) mehrere Strings (6) von Photovoltaikmodulen (7) über Stringleitungen (8, 9) parallel angeschlossen sind,
wobei die Detektionsvorrichtung aufweist:
- mindestens einen elektrischen Sensor (15, 16) in jeder Stromsammeleinheit (5), der Messwerte (18, 19) elektrischer Größen
- an mindestens einer der Stringleitungen (8, 9) jedes Strings (6) und/oder
- an mindestens einer Vorsammelleitung jedes Paars von Vorsammelleitungen, an das mehrere Strings (6) parallel angeschlossen sind, und/oder
- an mindestens einer der Sammelleitungen (3, 4) von jeder Stromsammeleinheit (5)
erfasst,
- eine Analyseeinrichtung (17), an die alle elektrischen Sensoren (15, 16) angeschlossen sind und die dazu ausgebildet ist, die Messwerte (18, 19) der elektrischen Größen auf das Vorliegen von Hinweisen auf einen Lichtbogen (14) in der Photovoltaikanlage (1) zu analysieren und ein Lichtbogensignal (20) zu generieren, das das Vorhandensein eines Lichtbogens (14) in der Photovoltaikanlage (1) anzeigt, wenn die vorliegenden Hinweise auf den Lichtbogen (14) vorgegebene Kriterien erfüllen,
**dadurch gekennzeichnet,**
- **dass** die Detektionsvorrichtung weiterhin mindestens einen akustischen Sensor aufweist, der Messwerte (25 bis 28) akustischer Größen
- an mindestens einer Sammelleitung (3, 4) von jeder Stromsammeleinheit (5) und/oder
- an mindestens einer dem Wechselrichter (2) zugeordneten Stromsammelschiene, an die eine Sammelleitung (3, 4) von jeder Stromsammeleinheit (5) angeschlossen ist,
erfasst,
- wobei der akustische Sensor an die Analyseeinrichtung (17) angeschlossen ist und wobei die Analyseeinrichtung (17) dazu ausgebildet ist, auch die Messwerte (25 bis 28) der akustischen Größen auf das Vorliegen von Hinweisen auf einen Lichtbogen (14) in der Photovoltaikanlage (1) zu analysieren.

9. Detektionsvorrichtung nach Anspruch 8, **dadurch gekennzeichnet, dass** die Analyseeinrichtung (17) dazu ausgebildet ist, das Lichtbogensignal (20) zu generieren, wenn die vorliegenden Hinweise auf den Lichtbogen (14) vorgegebene Kriterien erfüllen, die eine Kombination von Hinweisen auf den Lichtbogen (14) bei den Messwerten (18, 19) der elektrischen Größen und den Messwerten (25 bis 28) der akustischen Größen umfassen.

10. Detektionsvorrichtung nach Anspruch 9, **dadurch gekennzeichnet, dass** der mindestens eine elektrische Sensor (15, 16) die Messwerte (18, 19) der elektrischen Größen und/oder der mindestens eine akustische Sensor die Messwerte (25 bis 28) der akustischen Größen mit Zeitstempeln versieht, die den Zeitpunkt ihrer Erfassung angeben.

11. Detektionsvorrichtung nach Anspruch 9 und Anspruch 10, **dadurch gekennzeichnet, dass** die Analyseeinrichtung (17) bei der Kombination von Hinweisen auf den Lichtbogen (14) die Zeitstempel der Messwerte (18, 19) der elektrischen Größen und/oder der Messwerte (25 bis 28) der akustischen Größen berücksichtigt.

12. Detektionsvorrichtung nach einem der Ansprüche 7 bis 11, **dadurch gekennzeichnet, dass** der mindestens eine akustische Sensor ein Körperschallsensor (21 bis 24) ist, der Frequenz und/oder Amplitude von Körperschallschwingungen der jeweiligen Sammelleitung (3, 4) oder Stromsammelschiene (10, 11) erfasst.

13. Detektionsvorrichtung nach einem der Ansprüche 7 bis 12, **dadurch gekennzeichnet, dass** der mindestens eine elektrische Sensor einen Stromsensor (15) umfasst, der Frequenz und/oder Amplitude von Strömen durch die jeweilige Stringleitung (8, 9) oder Vorsammelleitung oder Sammelleitung (3, 4) erfasst, und/oder dass der mindestens eine elektrische Sensor einen Spannungssensor (16) umfasst, der
- Frequenz und/oder Amplitude von Spannungen zwischen den jeweiligen Stringleitungen (8, 9) oder Vorsammelleitungen oder Sammelleitungen (3, 4) und/oder
- Frequenz und/oder Amplitude von Spannungen zwischen einer der jeweiligen Stringleitungen (8, 9) oder Vorsammelleitungen oder Sammelleitungen (3, 4) und Erde erfasst.

14. Detektionsvorrichtung nach einem der Ansprüche 7 bis 13, **dadurch gekennzeichnet, dass** jede Sammeleinheit (5) eine zwischen den Stringleitungen (8, 9) wirksame Abschlusskapazität (31) aufweist und dass der mindestens eine elektrische Sensor (15, 16) die Messwerte der elektrischen Größen auf einer den Strings (6) zugekehrten Seite der Abschlusskapazität (31) erfasst.

15. Photovoltaikanlage (1) mit einem Wechselrichter (2), mit mehreren, über Sammelleitungen (3, 4) an den Wechselrichter (2) parallel angeschlossenen Stromsammeleinheiten (5), wobei an jede Stromsammeleinheit (5) mehrere Strings (6) von Photovoltaikmodulen (7) über Stringleitungen (8, 9) parallel angeschlossen sind, und mit einer Detektionsvorrichtung nach einem der Ansprüche 7 bis 14.

## Claims

1. Method for detecting arcing (14) in a photovoltaic system (1) with an inverter (2) and with a plurality of current collector units (5) connected in parallel to the inverter (2) via collector lines (3, 4), wherein a plurality of strings (6) of photovoltaic modules (7) are connected in parallel to each current collector unit (5) via string lines (8, 9),
wherein the method comprises:
- acquiring measured values (18, 19) of electrical variables
- at at least one of the string lines (8, 9) of each string (6), and/or
- at at least one upstream collector line of each pair of upstream collector lines to which a plurality of strings (6) are connected in parallel, and/or
- at at least one of the collector lines (3, 4) of each current collector unit (5) in the current collector units (5),
- analysing the measured values (18, 19) of the electrical variables for the presence of signs of an arc (14) in the photovoltaic system (1),
- generating an arc signal (20) which indicates the presence of an arc (14) in the photovoltaic system (1) if the present signs of the arc (14) meet predefined criteria,
**characterized in that** the method also comprises:
- acquiring measured values (25 to 28) of acoustic variables
- at at least one collector line (3, 4) of each current collector unit (5), and/or
- at at least one current busbar assigned to the inverter (2), to which current busbar a collector line (3, 4) of each current collector unit (5) is connected, and
- analysing the measured values (25 to 28) of the acoustic variables for the presence of signs of an arc (14) in the photovoltaic system (1).

2. Method according to Claim 1, **characterized in that** the acoustic variables comprise frequency and/or amplitude of structure-borne noise vibrations of the respective collector line (3, 4) or current busbar (10, 11).

3. Method according to either of the preceding claims, **characterized in that** the electrical variables the measured values (18, 19) of which are acquired in the current collector units (5) comprise
- frequency and/or amplitude of currents through the respective string line (8, 9) or upstream collector line or collector line (3, 4), and/or
- frequency and/or amplitude of voltages between the respective string lines (8, 9) or upstream collector lines or collector lines (3, 4), and/or
- frequency and/or amplitude of voltages between one of the respective string lines (8, 9), upstream collector lines or collector lines (3, 4) and ground.

4. Method according to Claim 3, **characterized in that** the measured values of the electrical variables are acquired on a side, facing the strings (6), of a termination capacitor (31) which acts between the string lines (8, 9).

5. Method according to any of the preceding claims, **characterized in that** the measured values (18, 19) of the electrical variables and/or the measured values (25 to 28) of the acoustic variables are provided with time stamps which specify their instant of acquisition.

6. Method according to any of the preceding claims, **characterized in that** the predefined criteria comprise a combination of signs of the arc (14) in the case of the measured values (18, 19) of the electrical variables and the measured values (25 to 28) of the acoustic variables.

7. Detection device for arcs (14) in a photovoltaic system (1) with an inverter (2) and with a plurality of current collector units (5) connected in parallel to the inverter (2) via collector lines (3, 4), wherein a plurality of strings (6) of photovoltaic modules (7) are connected in parallel to each current collector unit (5) via string lines (8, 9),
wherein the detection device comprises:
- at least one electrical sensor (15, 16) in each current collector unit (5), which acquires measured values (18, 19) of electrical variables
- at at least one of the string lines (8, 9) of each string (6), and/or
- at at least one upstream collector line of each pair of upstream collector lines to which a plurality of strings (6) are connected in parallel, and/or
- at at least one of the collector lines (3, 4) of each current collector unit (5),
- at least one analysis device (17) to which at least all of the electrical sensors (15, 16) present in one current collector unit (5) are connected and which is designed to analyse the measured values (18, 19) of the electrical variables for the presence of signs of an arc (14) in the photovoltaic system (1) and to generate an arc signal (20) which indicates the presence of an arc (14) in the photovoltaic system (1) if the present signs of the arc (14) meet predefined criteria,
**characterized**
- **in that** the detection device also comprises at least one acoustic sensor which acquires measured values (25 to 28) of acoustic variables,
- at at least one collector line (3, 4) of each current collector unit (5), and/or
- at at least one current busbar assigned to the inverter (2), to which current busbar a collector line (3, 4) of each current collector unit (5) is connected,
- wherein the at least one acoustic sensor is connected to a further analysis device (29) and wherein the further analysis device (29) is designed to analyse the measured values (25 to 28) of the acoustic variables for the presence of signs of an arc (14) in the photovoltaic system (1) and to generate an arc signal (30) which indicates the presence of an arc (14) in the photovoltaic system (1) if the present signs of the arc (14) meet predefined criteria.

8. Detection device for arcs (14) in a photovoltaic system (1) with an inverter (2) and with a plurality of current collector units (5) connected in parallel to the inverter (2) via collector lines (3, 4), wherein a plurality of strings (6) of photovoltaic modules (7) are connected in parallel to each current collector unit (5) via string lines (8, 9),
wherein the detection device comprises:
- at least one electrical sensor (15, 16) in each current collector unit (5), which acquires measured values (18, 19) of electrical variables
- at at least one of the string lines (8, 9) of each string (6), and/or
- at at least one upstream collector line of each pair of upstream collector lines to which a plurality of strings (6) are connected in parallel, and/or
- at at least one of the collector lines (3, 4) of each current collector unit (5),
- an analysis device (17) to which all of the electrical sensors (15, 16) are connected and which is designed to analyse the measured values (18, 19) of the electrical variables for the presence of signs of an arc (14) in the photovoltaic system (1) and to generate an arc signal (20) which indicates the presence of an arc (14) in the photovoltaic system (1) if the present signs of the arc (14) meet predefined criteria,
**characterized**
- **in that** the detection device also comprises at least one acoustic sensor which acquires measured values (25 to 28) of acoustic variables,
- at at least one collector line (3, 4) of each current collector unit (5), and/or
- at at least one current busbar assigned to the inverter (2), to which current busbar a collector line (3, 4) of each current collector unit (5) is connected,
- wherein the one acoustic sensor is connected to the analysis device (17) and wherein the analysis device (17) is designed to also analyse the measured values (25 to 28) of the acoustic variables for the presence of signs of an arc (14) in the photovoltaic system (1).

9. Detection device according to Claim 8, **characterized in that** the analysis device (17) is designed to generate the arc signal (20) if the present signs of the arc (14) meet predefined criteria, which comprise a combination of signs of the arc (14) in the case of the measured values (18, 19) of the electrical variables and the measured values (25 to 28) of the acoustic variables.

10. Detection device according to Claim 9, **characterized in that** the at least one electrical sensor (15, 16) provides the measured values (18, 19) of the electrical variables with time stamps which specify their instant of acquisition and/or the at least one acoustic sensor provides the measured values (25 to 28) of the acoustic variables with time stamps which specify their instant of acquisition.

11. Detection device according to Claim 9 and Claim 10, **characterized in that** the analysis device (17) takes into account the time stamps of the measured values (18, 19) of the electrical variables and/or the measured values (25 to 28) of the acoustic variables in the combination of signs of the arc (14).

12. Detection device according to any of Claims 7 to 11, **characterized in that** the at least one acoustic sensor is a structure-borne noise sensor (21 to 24) which acquires the frequency and/or amplitude of structure-borne noise vibrations of the respective collector line (3, 4) or current busbar (10, 11).

13. Detection device according to any of Claims 7 to 12, **characterized in that** the at least one electrical sensor comprises a current sensor (15), which acquires the frequency and/or amplitude of currents through the respective string line (8, 9) or upstream collector line or collector line (3, 4), and/or **in that** the at least one electrical sensor comprises a voltage sensor (16), which acquires
- frequency and/or amplitude of voltages between the respective string lines (8, 9) or upstream collector lines or collector lines (3, 4), and/or
- frequency and/or amplitude of voltages between one of the respective string lines (8, 9) or upstream collector lines or collector lines (3, 4) and ground.

14. Detection device according to any of Claims 7 to 13, **characterized in that** each collector unit (5) comprises a termination capacitor (31) which acts between the string lines (8, 9) and **in that** the at least one electrical sensor (15, 16) acquires the measured values of the electrical variables on a side, facing the strings (6), of the termination capacitor (31).

15. Photovoltaic system (1) with an inverter (2) and with a plurality of current collector units (5) connected in parallel to the inverter (2) via collector lines (3, 4), wherein a plurality of strings (6) of photovoltaic modules (7) are connected in parallel to each current collector unit (5) via string lines (8, 9), and with a detection device according to any of Claims 7 to 14.

## Revendications

1. Procédé pour détecter des arcs électriques (14) dans une installation photovoltaïque (1) avec un onduleur (2) et avec plusieurs unités de collecte de courant (5) raccordées en parallèle à l'onduleur (2) par des lignes collectrices (3, 4), dans lequel plusieurs chaînes (6) de modules photovoltaïques (7) sont raccordés en parallèle à chaque unité collectrice de courant (5) par des lignes de chaîne (8, 9), dans lequel le procédé comprend les étapes suivantes:
- détecter des valeurs de mesure (18, 19) de grandeurs électriques
- à au moins une des lignes de chaîne (8, 9) de chaque chaîne (6) et/ou
- à au moins une ligne précollectrice de chaque paire de lignes précollectrices, à laquelle plusieurs chaînes (6) sont raccordés en parallèle, et/ou
- à au moins une des lignes collectrices (3, 4) de chaque unité collectrice de courant (5) dans les unités collectrices de courant (5),
- analyser les valeurs de mesure (18, 19) des grandeurs électriques quant à la présence d'indices d'un arc électrique (14) dans l'installation photovoltaïque (1),
- générer un signal d'arc électrique (20), qui indique la présence d'un arc électrique (14) dans l'installation photovoltaïque (1), lorsque les indices d'arc électrique (14) présents remplissent des critères prédéterminés,
**caractérisé en ce que** le procédé comprend en outre les étapes suivantes:
- détecter des valeurs de mesure (25 à 28) de grandeurs acoustiques
- à au moins une ligne collectrice (3, 4) de chaque unité collectrice de courant (5) et/ou
- à au moins un rail collecteur de courant associé à l'onduleur (2), auquel une ligne collectrice (3, 4) de chaque unité collectrice de courant (5) est raccordée, et
- analyser les valeurs de mesure (25 à 28) des grandeurs acoustiques quant à la présence d'indices d'un arc électrique (14) dans l'installation photovoltaïque (1).

2. Procédé selon la revendication 1, **caractérisé en ce que** les grandeurs acoustiques comprennent la fréquence et/ou l'amplitude des vibrations acoustiques de la structure des lignes collectrices respectives (3, 4) ou du rail collecteur de courant (10, 11).

3. Procédé selon l'une des revendications précédentes, **caractérisé en ce que** les grandeurs électriques, dont les valeurs de mesure (18, 19) sont détectées dans les unités collectrices de courant (5), comprennent
- la fréquence et/ou l'amplitude de courants à travers la ligne de chaîne (8, 9) ou la ligne précollectrice ou la ligne collectrice (3, 4) respectivement et/ou
- la fréquence et/ou l'amplitude de tensions entre les lignes de chaîne (8, 9) ou les lignes précollectrices ou les lignes collectrices (3, 4) respectivement et/ou
- la fréquence et/ou l'amplitude de tensions entre une des lignes de chaîne (8, 9), des lignes précollectrice ou des lignes collectrices respectivement et la terre.

4. Procédé selon la revendication 3, **caractérisé en ce que** l'on détecte les valeurs de mesure des grandeurs électriques sur un côté, tourné vers un des chaînes (6), d'un condensateur terminal (31) actif entre les lignes de chaîne (8, 9).

5. Procédé selon l'une quelconque des revendications précédentes, **caractérisé en ce que** les valeurs de mesure (18, 19) des grandeurs électriques et/ou les valeurs de mesure (25 à 28) des grandeurs acoustiques sont munies de marques temporelles, qui indiquent l'instant de leur détection.

6. Procédé selon l'une quelconque des revendications précédentes, **caractérisé en ce que** les critères prédéterminés comprennent une combinaison d'indices de l'arc électrique (14) avec les valeurs de mesure (18, 19) des grandeurs électriques et les valeurs de mesure (25 à 28) des grandeurs acoustiques.

7. Dispositif pour détecter des arcs électriques (14) dans une installation photovoltaïque (1) avec un onduleur (2) et plusieurs unités collectrices de courant (5) raccordées en parallèle à l'onduleur (2) par des lignes collectrices (3, 4), dans lequel plusieurs chaînes (6) de modules photovoltaïques (7) sont raccordés en parallèle à chaque unité collectrice de courant (5) par des lignes de chaîne (8, 9),
dans lequel le dispositif de détection présente:
- au moins un détecteur électrique (15, 16) dans chaque unité collectrice de courant (5), qui détecte des valeurs de mesure (18, 19) de grandeurs électriques
- à au moins une des lignes de chaîne (8, 9) de chaque chaîne (6) et/ou
- à au moins une ligne précollectrice de chaque paire de lignes précollectrices, à laquelle plusieurs chaînes (6) sont raccordés en parallèle, et/ou
- à au moins une des lignes collectrices (3, 4) de chaque unité collectrice de courant (5),
- au moins un dispositif d'analyse (17), auquel au moins tous les détecteurs électriques (15, 16) présents dans une unité collectrice de courant (5) sont raccordés et qui est configuré de façon à analyser les valeurs de mesure (18, 19) des grandeurs électriques quant à la présence d'indices d'un arc électrique (14) dans l'installation photovoltaïque (1) et de générer un signal d'arc électrique (20), qui indique la présence d'un arc électrique (14) dans l'installation photovoltaïque (1), lorsque les indices d'un arc électrique (14) présents remplissent des critères prédéterminés,
**caractérisé en ce que**
- le dispositif de détection présente en outre au moins un détecteur acoustique, qui détecte des valeurs de mesure (25 à 28) de grandeurs acoustiques
- à au moins une ligne collectrice (3, 4) de chaque unité collectrice de courant (5) et/ou
- à au moins un rail collecteur de courant associé à l'onduleur (2), auquel une ligne collectrice (3, 4) de chaque unité collectrice de courant (5) est raccordée,
- dans lequel ledit au moins un détecteur acoustique est raccordé à un autre dispositif d'analyse (29) et dans lequel l'autre dispositif d'analyse (29) est configuré de façon à analyser les valeurs de mesure (25 à 28) des grandeurs acoustiques quant à la présence d'indices d'un arc électrique (14) dans l'installation photovoltaïque (1) et de générer un signal d'arc électrique (30), qui indique la présence d'un arc électrique (14) dans l'installation photovoltaïque (1) lorsque les indices d'un arc électrique (14) présents remplissent des critères prédéterminés.

8. Dispositif pour détecter des arcs électriques (14) dans une installation photovoltaïque (1) avec un onduleur (2) et avec plusieurs unités collectrices de courant (5) raccordées en parallèle à l'onduleur (2) par des lignes collectrices (3, 4), dans lequel plusieurs chaînes (6) de modules photovoltaïques (7) sont raccordés en parallèle à chaque unité collectrice de courant (5) par des lignes de chaîne (8, 9),
dans lequel le dispositif de détection présente:
- au moins un détecteur électrique (15, 16) dans chaque unité collectrice de courant (5), qui détecte des valeurs de mesure (18, 19) de grandeurs électriques
- à au moins une des lignes de chaîne (8, 9) de chaque chaîne (6) et/ou
- à au moins une ligne précollectrice de chaque paire de lignes précollectrices, à laquelle plusieurs chaînes (6) sont raccordés en parallèle, et/ou
- à au moins une des lignes collectrices (3, 4) de chaque unité collectrice de courant (5),
- un dispositif d'analyse (17), auquel tous les détecteurs électriques (15, 16) sont raccordés et qui est configuré de façon à analyser les valeurs de mesure (18, 19) des grandeurs électriques quant à la présence d'indices d'un arc électrique (14) dans l'installation photovoltaïque (1) et de générer un signal d'arc électrique (20), qui indique la présence d'un arc électrique (14) dans l'installation photovoltaïque (1), lorsque les indices d'un arc électrique (14) présents remplissent des critères prédéterminés,
**caractérisé en ce que**
- le dispositif de détection présente en outre au moins un détecteur acoustique, qui détecte des valeurs de mesure (25 à 28) de grandeurs acoustiques
- à au moins une ligne collectrice (3, 4) de chaque unité collectrice de courant (5) et/ou
- à au moins un rail collecteur de courant associé à l'onduleur (2), auquel une ligne collectrice (3, 4) de chaque unité collectrice de courant (5) est raccordée,
- dans lequel le détecteur acoustique est raccordé au dispositif d'analyse (17) et dans lequel le dispositif d'analyse (17) est configuré de façon à analyser aussi les valeurs de mesure (25 à 28) des grandeurs acoustiques quant à la présence d'indices d'un arc électrique (14) dans l'installation photovoltaïque (1).

9. Dispositif de détection selon la revendication 8,
**caractérisé en ce que** le dispositif d'analyse (17) est configuré de façon à générer le signal d'arc électrique (20), lorsque les indices d'un arc électrique (14) présents remplissent des critères prédéterminés, qui comprennent une combinaison d'indices d'un arc électrique (14) avec les valeurs de mesure (18, 19) des grandeurs électriques et des valeurs de mesure (25 à 28) des grandeurs acoustiques.

10. Dispositif de détection selon la revendication 9,
**caractérisé en ce que** ledit au moins un détecteur électrique (15, 16) munit les valeurs de mesure (18, 19) des grandeurs électriques et/ou ledit au moins un détecteur acoustique munit les valeurs de mesure (25 à 28) des grandeurs acoustiques de marques temporelles, qui indiquent l'instant de leur détection.

11. Dispositif de détection selon la revendication 9 et la revendication 10, **caractérisé en ce que** le dispositif d'analyse (17) tient compte, lors de la combinaison d'indices d'un arc électrique (14), des marques temporelles des valeurs de mesure (18, 19) des grandeurs électriques et/ou des valeurs de mesure (25 à 28) des grandeurs acoustiques.

12. Dispositif de détection selon l'une quelconque des revendications 7 à 11, **caractérisé en ce que** ledit au moins un détecteur acoustique est un détecteur de vibrations acoustiques (21 à 24), qui détecte la fréquence et/ou l'amplitude de vibrations acoustiques de la structure de la ligne collectrice (3, 4) ou du rail collecteur de courant (10, 11) respectivement.

13. Dispositif de détection selon l'une quelconque des revendications 7 à 12, **caractérisé en ce que** ledit au moins un détecteur électrique comprend un détecteur de courant (15), qui détecte la fréquence et/ou l'amplitude de courants à travers la ligne de chaîne (8, 9) ou la ligne précollectrice ou la ligne collectrice (3, 4) respectivement, et/ou **en ce que** ledit au moins un détecteur électrique comprend un détecteur de tension (16), qui détecte
- la fréquence et/ou l'amplitude de tensions entre les lignes de chaîne (8, 9) ou les lignes précollectrices ou les lignes collectrices (3, 4) respectivement et/ou
- la fréquence et/ou l'amplitude de tensions entre une des lignes de chaîne (8, 9) ou des lignes précollectrices ou des lignes collectrices (3, 4) respectivement et la terre.

14. Dispositif de détection selon l'une quelconque des revendications 7 à 13, **caractérisé en ce que** chaque unité collectrice (5) présente un condensateur terminal (31) actif entre les lignes de chaîne (8, 9) et **en ce que** ledit au moins un détecteur électrique (15, 16) détecte les valeurs de mesure des grandeurs électriques sur un côté du condensateur terminal (31) tourné vers un des chaînes (6).

15. Installation photovoltaïque (1) avec un onduleur (2), avec plusieurs unités collectrices de courant (5) raccordées en parallèle à l'onduleur (2) par des lignes collectrices (3, 4), dans laquelle plusieurs chaînes (6) de modules photovoltaïques (7) sont raccordés en parallèle à chaque unité collectrice de courant (5) par des lignes de chaîne (8, 9), et avec un dispositif de détection selon l'une quelconque des revendications 7 à 14.
